# EUROPEAN PATENT APPLICATION

(11) **EP 1 569 215 A1**
(43) Date of publication of application: **31.08.2005**
(21) Application number: 03777368.6
(22) Date of filing: 09.12.2003
(51) Int. Cl.: G11B 7/26, G11B 7/24, C23C 14/34, C22C 5/06

(54) **SILVER ALLOY FOR REFLECTIVE FILM OF OPTICAL RECORDING MEDIUM**

(30) Priority: 10.12.2002 JP 2002358040
(71) Applicant: TANAKA KIKINZOKU KOGYO KABUSHIKI KAISHA, Tokyo 103-8206 (JP)
(72) Inventor: KEDUKA, Hiroyuki, c/o TANAKA KIKINZOKU KOGYO K.K., Isehara-shi, Kanagawa 259-1146 (JP); YANAGIHARA, Hiroshi, TANAKA KIKINZOKU KOGYO K.K., Isehara-shi, Kanagawa 259-1146 (JP)
(74) Representative: Moy, David
(86) International application number: PCT/JP2003/015696
(87) International publication number: WO 2004/053861

(57) **Abstract**

The present invention provides a silver alloy for use in a reflection coating for an optical recording medium, comprising silver as a main component and indium and/or tin as an additive element. It is preferable when the concentration of the additive elements falls within 0.1-25wt%, and reflectivity can be inhibited from deteriorating especially when the concentration falls within a range of 0.1-5.0wt%. When the thermal conductivity of the reflective layer is taken into account, the concentration of the additive elements may be further limited to 0.1-0.5wt% to provide a reflective layer of higher thermal conductivity.

## Description

### TECHNICAL FIELD

The present invention relates to a silver alloy suitable as a constituent material for a reflection coating for an optical recording medium, especially to a silver alloy for a reflection coating, which is capable of inhibiting decrease in reflectivity during a long-term service.

### BACKGROUND ART

Optical recording media such as CD-ROM, DVD-ROM or the like normally comprise a substrate on which a recording layer, a reflection coating layer and a protective layer (i.e. overcoat) are provided. As a reflection coating layer, an aluminum alloy has been used conventionally from the viewpoint of cost and reflectivity. However, application of materials having higher reflectivity has been demanded as the mainstream of optical recording media shifts to recordable or rewritable ones (CD-R/RW, DVD-R/RW/RAM). This is attributable to a fact that organic dye materials have been widely used as a constituent material for a recording layer in recordable or rewritable media, and organic dye materials allow extinction of a light beam to become great, so that the extinction should be compensated by improved reflectivity of a reflective layer.

In terms of reflectivity, it is silver that has been applied as a material for a reflective layer in an optical recording medium. Silver is a suitable material in view of higher reflectivity and moderate price compared to gold, which also has higher reflectivity. However, silver has a disadvantage that it is poor in oxidation resistance and sulfur resistance, hence it readily corrodes due to oxydation or sulfuration and will turn black to deteriorate the reflectivity.

In order to address a problem of deterioration in reflectivity associated with the use of an optical recording medium, efforts have been conventionally made to develop optical recording media, to which silver alloy is applied as a reflective layer to increase corrosion resistance while reflectivity is secured. Many of these media have adopted silver as a main component, to which one, two or more different additive elements should be added. Specifically, some cases have been disclosed where 5-10at% ruthenium and 0.1-10at% aluminum are added to silver, or 0.5-4.9at% palladium is added. It is further disclosed that these silver alloys have good corrosion resistance and can maintain reflectivity under an operating environment, thereby being suitable as a reflective layer (See Japanese Patent Publication Laid-Open Nos. Hei 11-134715 and 2000-109943 for details of these prior art).

Certain degree of improvement has been recognized in terms of corrosion resistance in connection with the above-discussed silver alloys. However, these silver alloys are not always corrosion-free under some operating environments. Moreover, deterioration in reflectivity has not been addressed completely, so that such materials capable of maintaining reflectivity in a higher dimension are demanded.

In the field of optical recorders, red semiconductor laser (wavelength of 650nm) is currently applied as a light source for recording, however practical use of blue laser (wavelength of 405nm) has been in sight recently. Application of blue laser can insure a five- or six-fold storage capacity compared to the present optical recorders, so that it is considered blue laser-applied optical recorders will become mainstream in the next-generation ones. In this regard, the present inventors have confirmed the reflectivity of a reflective layer will fluctuate in accordance with the wavelength of laser to be irradiated, and especially have confirmed irradiation of laser having a short-wavelength will cause deterioration in reflectivity irrespective of presence or absence of corrosion and the deterioration in reflectivity due to corrosion will be prominent more frequently than in a case of irradiation of laser having a long-wavelength. Thus, in order to manufacture recording media capable of addressing the future development of light sources for recording, it is desired a development of materials having a higher reflectivity with respect to irradiation of laser of short-wavelength band and capable of maintain a further practical scope of use.

The present invention has been made with the above matters as a background, and it relates to a silver alloy composing a reflective layer in an optical recording medium. It is an objective of the invention to provide a material for a reflective layer, capable of serving with the reflectivity kept not deteriorated due to a long-term use. Furthermore, the present invention provides a material having a higher reflectivity with respect to laser beams of short-wavelength.

### DISCLOSURE OF THE INVENTION

In order to solve the above problem, the present inventors determined to adopt silver as a main component as had been done in the earlier technologies, and to discover suitable materials for a reflective layer from a different viewpoint from the earlier technologies. The reason that silver was selected as a main component is based on consideration of the advantages (higher reflectivity and lower cost) that silver has as discussed above. An approach that the present inventors made in a different manner from conventional one was to address the improvement of corrosion resistance only, through adding additive elements as had been done in the earlier technologies. Specifically, corrosion (oxidation) of a reflective layer during use is inevitable in a practical sense. Therefore, the present inventors considered such a silver alloy suitable as a material for a reflective layer if it is not deteriorated in reflectivity when oxidized, while daring to permit oxidation during use. The present inventors came up with the present invention through discovering a silver alloy causing no deterioration in reflectivity when oxidized, to which added are/is indium and/or tin which are preferentially oxidized over silver and do not affect the reflectivity.

The present invention relates to a silver alloy for use in a reflection coating for an optical recording medium, which comprises silver as a main component and indium and/or tin as an additive element.

Oxides to which indium and/or tin have/has been added as an additive element in the present invention are transparent, as it is understandable from the fact that they have been widely applied as a transparent electrode material thus far. In the silver-indium/tin alloy according to the present invention, the indium and/or tin are/is oxidized during use and the oxide(s) are/is transparent, thereby causing no damage to the reflectivity of the alloy. Further in the alloy according to the present invention, indium oxide and tin oxide are dispersed within the alloy, and an oxide layer composed of indium oxide and tin oxide are formed on the surface of the alloy. The oxide layer serves as a protective layer for the alloy against further oxidation, and inhibits the silver to be a base material against oxidation. A reflective layer to be formed with the alloy according to the present invention is capable of maintaining a reflectivity with the action described above.

Some DVD-ROMs among optical recording media have a dual structure, in which the combination of a recording layer and a reflective coating layer have been made dual from the viewpoint of insuring memory capacity. When data are read out from the recording layer in the upper layer of the DVD-ROMs having a dual structure, it is necessary to change the focal point of an incident laser beam to allow the beam to transmit through the substrate and the recording layer and reflective layer in the lower layer. Therefore, a transmission property as well as reflection property are demanded to a reflective layer in a DVD-ROM. In this respect, the alloy according to the present invention is excellent in transmittance, and applicable to the reflective layers in a DVD-ROM having a dual structure.

The content of the indium and tin as being additive elements in the present invention will be preferably both 0.1-25wt% if maintenance of reflectivity should be taken into consideration. The reason is that when the added amount is less than 0.1, it is not effective in terms of maintenance of reflectivity, and when the concentration of added elements exceeds 25%, some environments and wavelengths of incident laser beams may substantially reduce the reflectivity, causing a major practical obstacle. Especially preferable concentration is 0.1-5.0wt%. The reason is that, if fallen within the range, the reflectivity can be maintained at higher levels regardless of the environment and wavelength of a laser beam. It should be noted that these ranges of concentration indicate for all the additive elements, and when both indium and tin are contained, it is indicated that the total concentration of each element is within these ranges.

The silver alloy according to the present invention is suitable as a material for use in a reflective layer for an optical recording medium, and it is enumerated a higher thermal conductivity as a preferable property if provided to a material for an reflective layer. The reason is that lower thermal conductivity of a reflective layer will deteriorate the sensitivity of a recording medium. Thus, the silver alloy according to the present invention, which imparts properties preferable in terms of both maintenance of reflectivity and higher thermal conductivity, will be further preferable if it is provided with a concentration of additive elements such as indium and tin 0.1-0.5wt%. The reason is that, according to the present inventors, such an alloy having a concentration of additive elements exceeding 5wt% has a lower thermal conductivity, and the additive elements will show only a fraction of the thermal conductivity of silver, which is a main component of the alloy.

As described above, the silver alloy according to the present invention can be produced through a melting and casting method. Production through the melting and casting method has no specific difficulties, and the silver alloy can be produced through a common method in which each raw material should be checkweighed, melted and mixed for casting.

In the meantime, actual production of a reflective layer most often conducted will be a formation of thin films thorough a sputtering method in which a target comprising a material for a reflective layer is employed. As described above, in the silver alloy according to the present invention, the iridium and tin contained are preferentially oxidized, and oxide thus generated will act as a protective film to insure inhibition of oxidization and sulfuration, which will happen subsequently. When a reflection coating is formed with the silver alloy according to the present invention, oxygen is mixed with argon gas, which is to be introduced to a sputtering apparatus used in a sputtering method, reactive sputtering is conducted to form the reflective layer while oxidizing the same, thereby forming a protective film at an earlier stage of a reflective layer formation.

Meanwhile, the reactive sputtering may undermine a production efficiency of a reflective layer because it needs subtle adjustment to an introduction of oxygen gas in order to regulate the degree of oxidation of a reflective layer. In this regard, the present inventors came up with an idea that in the present alloy, a normal sputtering process without introduction of oxygen gas, which requires subtle regulation can form a protective film to a reflective layer by preliminarily oxidizing indium and tin as additive elements. That is to say, the present inventors determined to oxide partially or entirely indium and/or tin as additive elements with respect to the silver alloy according to the present invention in which silver is a main component. They discovered a thin film produced with the internally oxidized alloy employed as a target will be formed to have oxides of indium and tin uniformly dispersed compared with the one at the production stage of a thin film.

Production of the internally oxidized silver alloy can be effected through: producing a silver alloy containing predetermined compositions of indium and/or tin; and pressurizing and heating the silver alloy in a highpressure oxygen atmosphere to allow the indium and tin in the alloy to be oxidized partially or entirely. As specific conditions for oxidation, it is preferable if the pressurization and heating are conducted in an atmosphere of oxygen tension 0.1-1MPa at 700-800°C for 60-80 hours.

The above-described silver alloy according to the present invention has preferable properties as a reflective layer, and has been inhibited from deteriorating in reflectivity during use. Further, the silver alloy shows better reflectivity and maintenance thereof compared to the conventional materials for a reflective layer even under irradiation of laser beams of short wavelength, as described later. As described above, a sputtering method is generally applied in producing a reflective layer for an optical recording medium. Thus, the sputtering target comprises of the silver alloy according to the present invention is contributive to production of an optical recording medium provided with a reflective layer having preferable properties.

### BEST MODE FOR CARRYING OUT THE INVENTION

Hereinafter, examples of the present invention will be described together with comparative examples.

### Example 1:

In this example, a target as a silver alloy composed of Ag, In 1.2wt%, and Sn 0.8wt% was produced, and a thin film was formed through sputtering with the use of this target. Thus formed thin film was subjected to corrosion tests (acceleration tests) under various environments for studying variations in reflectivity of post corrosion tests.

In producing a silver alloy, each metal was checkweighed to reach a predetermined concentration, and is molten and mixed in a high-frequency melting furnace to prepare an alloy. Then, it was poured into a mold to solidify for preparing an ingot, which was forged, rolled, heat treated, and formed to produce a target.

In producing a thin film, a substrate (borosilicate glass) and a target were placed in a sputtering apparatus. After a vacuum was drawn in the apparatus to a level of 5.0 × 10⁻³Pa, argon gas was introducedintroduced to a level of 5.00 × 10⁻¹Pa. A film was formed under sputtering conditions with 1kW of direct-current and time period of 1 minute to make the film thickness 1000Å, Distribution of the film thickness was confirmed within ±10%.

A corrosion test of a thin film was done with the thin film exposed to each environment described below and with the reflectivity of a tested thin film measured while a wavelength was changed with the use of a spectrophotometer, and variation in reflectivity was inspected with the reflectivity of the silver of immediately after film formation standardized.

### (1) Heating at 250°C for 2 hours in the atmosphere

The thin film was placed on a hot plate, and was heated in accordance with the above prescribed temperature and duration of time. This test environment is for inspecting an oxidization resistance of the thin film.

### (2) Soaking in warm water for 30 minutes

The thin film was soaked in pure water of 60°C. This test environment is for inspecting a moisture resistance of the thin film.

### (3) Soaking in an alkaline solution

The thin film was soaked in a sodium hydroxide solution of 3% (temperature 30°C) for 10 minutes. This test environment is for inspecting an alkaline resistance of the thin film.

### Comparative Example:

As a comparison with the silver alloy according to the present examples, thin films were produced from three targets composed of silver alloys, specifically of Ag-1.0wt% Au-1.0wt% Cu, Ag-1.0wt% Pd-1.0wt% Cu, and Ag-1.0wt% Nd-1.0wt% Cu, and corrosion tests similar to the above-described one were conducted to measure likewise variations in reflectivity.

The results of the corrosion tests in this example will be shown in Tables 1 through 3. The reflectivity as shown in Tables are relative values when the reflectivity of the silver of immediately after film formation is set to 100. Each measured value represents reflectivity in the wavelengths of 400nm, 560nm, and 650nm (corresponding to the wavelength of blue, yellow, and red laser, respectively.).

**Table 1**

| Wavelength of incident light: 650nm | | | | |
|---|---|---|---|---|
| | Example 1 | Comparative Example | | |
| | Ag-In-Sn | Ag-Au-Cu | Ag-Pd-Cu | Ag-Nd-Cu |
| Immediately after film formation | 97 | 83 | 84 | 88 |
| 250°C-2.0h | 94 | 88 | 92 | 93 |
| Soaking in warm water | 95 | 85 | 88 | 90 |
| Soaking in alkali | 96 | 95 | 95 | 90 |
| Average value | 96 | 88 | 90 | 90 |

**Table 2**

| Wavelength of incident light: 560nm | | | | |
|---|---|---|---|---|
| | Example 1 | Comparative Example | | |
| | Ag-In-Sn | Ag-Au-Cu | Ag-Pd-Cu | Ag-Nd-Cu |
| Immediately after film formation | 95 | 82 | 80 | 80 |
| 250°C-2.0h | 91 | 82 | 88 | 90 |
| Soaking in warm water | 94 | 84 | 84 | 82 |
| Soaking in alkali | 94 | 93 | 93 | 82 |
| Average value | 94 | 85 | 86 | 84 |

**Table 3**

| Wavelength of incident light: 400nm | | | | |
|---|---|---|---|---|
| | Example 1 | Comparative Example | | |
| | Ag-In-Sn | Ag-Au-Cu | Ag-Pd-Cu | Ag-Nd-Cu |
| Immediately after film formation | 77 | 72 | 69 | 65 |
| 250°C-2.0h | 70 | 57 | 69 | 69 |
| Soaking in warm water | 78 | 72 | 71 | 65 |
| Soaking in alkali | 76 | 75 | 75 | 65 |
| Average value | 75 | 69 | 71 | 66 |

From the results, as the wavelength of incident light becomes shorter, the reflectivity will be deteriorated as a general trend (the same holds true for a thin film subjected no corrosion test immediately after film formation). The thin film produced from the silver alloy according to the present example shows higher values than any of the comparative examples in terms of reflectivity. Especially, the thin film according to the present example maintains the reflectivity of that of immediately after film formation with respect to one tested about corrosion under any environment. However, the comparative examples show fluctuations in reflectivity depending on the environment for the corrosion test. Therefore, it is known that the thin film according to the present invention is a more preferable one as a reflective layer than those according to the conventional technologies.

### Example 2:

In this example, a search was conducted in terms of the correlation between the concentration of additive elements and the reflectivity of post corrosion tests of the solver alloys, and the upper limits were examined. The silver alloys produced and employed in this example were Ag-Sn alloys, and silver alloys in which the tin concentration was varied in the ranges between 2-50wt% were examined. The method for producing the silver alloys in this example is the same as that in Example 1, however in terms of the corrosion test environment, a test in which the silver alloys were soaked in a 0.01% sodium sulfide solution (at the temperature of 25°C) for 1 hour was conducted to examine sulfur resistance, in addition to the test environment of Example 1. Measurement of the reflectivity after the corrosion test was conducted in a similar manner to that in example 1. The results are shown in Tables 4-6.

**Table 4**

| Wavelength of incident light: 650nm | | | | | |
|---|---|---|---|---|---|
| Sn concentration | Immediately after film formation | Corrosion test conditions | | | |
| | | Heating in the atmosphere (250°C × 2h) | Soaking in warm water (60°C × 0.5h) | Soaking in alkali (3% NaOH × 10min.) | Soaking in sulfide solution (0.01% Na₂S × 1h) |
| 2wt% | 100 | 95 | 99 | 99 | 98 |
| 3wt% | 99 | 97 | 99 | 99 | 98 |
| 4wt% | 98 | 97 | 99 | 98 | 94 |
| 5wt% | 97 | 97 | 98 | 98 | 86 |
| 10wt% | 93 | 96 | 90 | 87 | 89 |
| 15wt% | 77 | 87 | 85 | 84 | 80 |
| 20wt% | 89 | 91 | 84 | 78 | 85 |
| 25wt% | 84 | 86 | 84 | 85 | 84 |
| 30wt% | 84 | 84 | 62 | 81 | 83 |
| 40wt% | 78 | 76 | 72 | 78 | 77 |
| 50wt% | 70 | 74 | 73 | 55 | 72 |

**Table 5**

| Wavelength of incident light: 560nm | | | | | |
|---|---|---|---|---|---|
| Sn concentration | Immediately after film formation | Corrosion test conditions | | | |
| | | Heating in the atmosphere (250°C × 2h) | Soaking in warm water (60°C × 0.5h) | Soaking in alkali (3% NaOH × 10min.) | Soaking in sulfide solution (0.01% Na₂S × 1h) |
| 2wt% | 100 | 92 | 99 | 99 | 97 |
| 3wt% | 99 | 96 | 99 | 98 | 96 |
| 4wt% | 97 | 96 | 99 | 97 | 92 |
| 5wt% | 96 | 96 | 98 | 97 | 94 |
| 10wt% | 90 | 95 | 86 | 81 | 85 |
| 15wt% | 68 | 76 | 77 | 75 | 73 |
| 20wt% | 86 | 88 | 79 | 70 | 80 |
| 25wt% | 81 | 83 | 80 | 82 | 81 |
| 30wt% | 81 | 80 | 59 | 79 | 81 |
| 40wt% | 74 | 71 | 68 | 74 | 73 |
| 50wt% | 67 | 67 | 68 | 53 | 69 |

**Table 6**

| Wavelength of incident light: 400nm | | | | | |
|---|---|---|---|---|---|
| Sn concentration | Immediately after film formation | Corrosion test conditions | | | |
| | | Heating in the atmosphere (250°C × 2h) | Soaking in warm water (60°C × 0.5h) | Soaking in alkali (3% NaOH × 10min.) | Soaking in sulfide solution (0.01% Na₂S × 1h) |
| 2wt% | 96 | 71 | 97 | 94 | 90 |
| 3wt% | 90 | 84 | 95 | 89 | 87 |
| 4wt% | 83 | 81 | 93 | 87 | 75 |
| 5wt% | 83 | 76 | 88 | 82 | 80 |
| 10wt% | 75 | 84 | 71 | 68 | 71 |
| 15wt% | 61 | 56 | 67 | 65 | 60 |
| 20wt% | 73 | 67 | 65 | 60 | 65 |
| 25wt% | 72 | 66 | 71 | 73 | 73 |
| 30wt% | 72 | 61 | 52 | 70 | 72 |
| 40wt% | 66 | 55 | 61 | 66 | 64 |
| 50wt% | 63 | 46 | 55 | 51 | 63 |

Considering the above results, it is understood from the trend in the present example that adding an additive element of 25wt% or more will make reflectivity at an initial stage (i.e. immediately after film formation) lower depending on the wavelength of incident light, and when an acceptance criterion as a reflective layer is set to 60 (the reflectivity of silver being set to 100), the silver alloys having slight corrosion comes short of acceptance criterion in many cases. Therefore, it is estimated the upper limit of the content of the additive element is 25wt%. In order to keep the reflectivity as higher levels (i.e. to show values of 80 or higher), the concentration of the additive element should be preferably 5.0wt% or lower.

### Example 3:

For studying a lower limit of additive elements in this example, As-In Sn alloys containing indium and tin in a total amount of 0.05-0.5wt% were produced, and then thin films were produced from the alloys for measuring variations in reflectivity by way of corrosion tests. A production method of the alloys, environments for corrosion tests and other conditions are the same as those in Example 2. The results are shown in Tables 7-9.

**Table 7**

| Wavelength of incident light: 650nm | | | | | | | |
|---|---|---|---|---|---|---|---|
| Concentration of additive elements (wt%) | | | Immediately after film formation | Corrosion test conditions | | | |
| In | Sn | Total | | Heating in the atmosphere (250°C × 2h) | Soaking in warm water (60°C × 0.5h) | Soaking in alkali (3% NaOH × 10min.) | Soaking in sulfide solution (0.01% Na₂S × 1h) |
| 0.025 | 0.025 | 0.05 | 101 | 43 | 100 | 73 | 98 |
| 0.05 | 0.05 | 0.1 | 100 | 94 | 100 | 100 | 97 |
| 0.1 | 0.1 | 0.2 | 99 | 80 | 99 | 99 | 97 |
| 0.2 | 0.2 | 0.4 | 98 | 98 | 99 | 99 | 96 |
| 0.25 | 0.25 | 0.5 | 99 | 98 | 98 | 98 | 96 |

**Table 8**

| Wavelength of incident light: 560nm | | | | | | | |
|---|---|---|---|---|---|---|---|
| Concentration of additive element (wt%) | | | Immediately after film formation | Corrosion test conditions | | | |
| In | Sn | Total | | Heating in the atmosphere (250°C × 2h) | Soaking in warm water (60°C × 0.5h) | Soaking in alkali (3% NaOH × 10min.) | Soaking in sulfide solution (0.01% Na₂S × 1h) |
| 0.025 | 0.025 | 0.05 | 101 | 36 | 100 | 72 | 97 |
| 0.05 | 0.05 | 0.1 | 101 | 92 | 100 | 100 | 97 |
| 0.1 | 0.1 | 0.2 | 99 | 78 | 99 | 99 | 96 |
| 0.2 | 0.2 | 0.4 | 97 | 97 | 99 | 99 | 95 |
| 0.25 | 0.25 | 0.5 | 99 | 97 | 98 | 98 | 95 |

**Table 9**

| Wavelength of incident light: 400nm | | | | | | | |
|---|---|---|---|---|---|---|---|
| Concentration of additive elements (wt%) | | | Immediately after film formation | Corrosion test conditions | | | |
| In | Sn | Total | | Heating in the atmosphere (250°C × 2h) | Soaking in warm water (60°C × 0.5h) | Soaking in alkali (3% NaOH × 10min.) | Soaking in sulfide solution (0.01% Na₂S × 1h) |
| 0.025 | 0.025 | 0.05 | 105 | 20 | 103 | 73 | 96 |
| 0.05 | 0.05 | 0.1 | 104 | 78 | 103 | 103 | 95 |
| 0.1 | 0.1 | 0.2 | 97 | 62 | 98 | 97 | 94 |
| 0.2 | 0.2 | 0.4 | 93 | 88 | 95 | 95 | 91 |
| 0.25 | 0.25 | 0.5 | 89 | 83 | 93 | 92 | 89 |

Considering the results, it is understood the silver alloys studied in Example 3 have good reflectivity immediately after film formation, however have large variations in reflectivity due to heating in the atmosphere. It is shown a correlation between the concentration of additive elements and reflectivity, and as the concentration of additive elements becomes lower, the reflectivity after heating has a tendency to decrease. As in Example 2, when the acceptance criterion is set to 60, it is understood that the thin film having a concentration of additive elements of less than 0.1wt% (i.e. 0.05wt%) can no longer maintain the reflectivity of post-atmospheric oxidization. Therefore, it is considered appropriate to set the lower limit of the concentration of additive elements to 0.1wt%.

### Example 4:

For studying a correlation between the concentration of additive elements and thermal conductivity in this example, As-In-Sn alloys containing indium and tin in a total amount of 0.05-0.5wt% were produced, and then thin films were produced from the alloys for obtaining each thermal conductivity. The thin films were formed in the same manner as those in Examples 1 and 2. Since it is difficult to measure the thermal conductivity of the thin films directly, specific resistance was first measured to allow thermal conductivity to be obtained through calculation in accordance with Wiedemann-Franz law based on the measured values. The results are shown in Table 10. Table 10 specifically shows each thermal conductivity of three kinds of silver alloys as produced as Comparative Example of Example 1, which are of Ag-1.0wt% Au-1.0wt% Cu, Ag-1.0wt% Pd-1.0wt% Cu, and Ag-1.0wt% Nd-1.0wt% Cu, and the thermal conductivity of thin film of pure silver.

**Table 10**

| Concentration of additive elements (wt%) | | | Thermal conductivity Wm⁻¹K⁻¹ | | | | |
|---|---|---|---|---|---|---|---|
| In | Sn | Total | Ag-In-Sn (Present Example) | Ag | Ag-Au-Cu | Ag-Pd-Cu | Ag-Nd-Cu |
| 0.025 | 0.025 | 0.05 | 237 | 240 | 106 | 45 | 63 |
| 0.05 | 0.05 | 0.1 | 226 | | | | |
| 0.1 | 0.1 | 0.2 | 196 | | | | |
| 0.2 | 0.2 | 0.4 | 163 | | | | |
| 0.25 | 0.25 | 0.5 | 122 | | | | |
| 1.0 | 1.0 | 2.0 | 76 | | | | |

It is understood from Table 10 that the Ag-In-Sn alloy thin film according to the present example exhibits thermal conductivity which decreases in proportion to increase in the concentration of additive elements. When an acceptance line of thermal conductivity is set to be 50% or higher of that of silver, it is considered appropriate to hold the added amount of the additive elements below 0.5wt% in view of the thermal conductivity. When the results of Example 3 are taken into consideration, it was confirmed preferable concentration of additive elements in terms of two conditions, namely maintenance of reflectivity and high thermal conductivity, ranges 0.1 and 0.5wt%. It was also confirmed every silver alloy thin film according to Comparative Example has thermal conductivity of less than 50% of that of silver.

### INDUSTRIAL APPLICABILITY

As described above and different from the conventional idea, the silver alloy according to the present invention inhibits reduction of reflectivity during use through addition of elements, which generate oxide that causes no adverse effects on reflectivity when get oxidized. The present invention can produce a reflective layer less likely to decrease in reflectivity due to long-term use, thereby prolonging the duration of life of an optical recording medium. Further, the silver alloy according to the present invention exhibits better reflectivity and maintenance thereof than the conventional materials for a reflective layer even if subjected to irradiation of laser having a short-wavelength. Thus, the present silver alloy is applicable to recording media for optical recorders adopting a short-wavelength laser as a light source and expected to be a future mainstream.

## Claims

1. A silver alloy for use in a reflection coating for an optical recording medium, comprising silver as a main component and indium and/or tin as an additive element

2. A silver alloy for use in a reflection coating for an optical recording medium according to claim 1, wherein said additive element has a concentration of 0.1-25wt%.

3. A silver alloy for use in a reflection coating for an optical recording medium according to claim 1, wherein said additive element has a concentration of 0.1-5.0wt%.

4. A silver alloy for use in a reflection coating for an optical recording medium according to claim 1, wherein said additive element has a concentration of 0.1-0.5wt%.

5. A silver alloy for use in a reflection coating for an optical recording medium according to claims 1-4, wherein the indium and/or tin as an additive element has been internally oxidized partially or wholly.

6. A sputtering target comprising the silver alloy according to claims 1-5.
